# EUROPEAN PATENT APPLICATION

(11) **EP 4 164 343 A1**
(43) Date of publication of application: **12.04.2023**
(21) Application number: 21306415.7
(22) Date of filing: 08.10.2021
(51) Int. Cl.: H05B 47/20, H05B 39/08, H05B 45/31, H02M 5/293, H03K 17/18, G05F 1/445, G01R 31/327

(54) **POWER CONTROL CIRCUIT, MONITORING APPARATUS, MONITORING SYSTEM**

(71) Applicant: Schneider Electric Industries SAS, 92500 Rueil-Malmaison (FR)
(72) Inventor: Kovác, Pavel, 769 01 Holesov (CZ); Hanacek, Kamil, 760 05 Zlín (CZ)
(74) Representative: Manitz Finsterwald Patent- und Rechtsanwaltspartnerschaft mbB

(57) **Abstract**

A power control circuit 1 for controlling power supply to an electrical load 2, the circuit (1) comprises terminals 11, 12 for being connected into one of said power lines, a switching circuit 14 comprising one or more semiconductor switches and connected with its terminals between the two terminals 11, 12 for switching over between a high-ohmic state and a low-ohmic state , a control component 15 for controlling switching of the switching circuit 14 according to a target value, a monitoring component 16 for monitoring a voltage across the switching circuit 14 or a voltage derived therefrom and generating a notice information when a predetermined condition of the monitored voltage is met, and a communication component 17 capable of holding an identification information for said power control circuit 1 and of communicating at least said identification information away from said power control circuit 1 upon occurrence of said notice information.

## Description

The invention relates to a power control circuit, to a monitoring apparatus and a monitoring system. The invented power control circuit may be a dimmer or another type of power control circuit capable of gradually controlling power supply from a source such as the power grid to a load such as illumination.

The power control circuit is suited for being inserted into the power supply line of an electrical consumer or load for controlling power supply from a source to said consumer. Control here is assumed to be preferably not only on/off, but also for gradual values between 0% and 100%. The controlled power may be AC voltage and may be that used in the large power supply grids, for example 230 V at 50 Hz or 110 V at 60 Hz.

For controlling electric power supply to a load between on and off, a well-known approach is phase angle control for forwarding only parts of the respective half waves to the consumer and cutting off the respective remaining parts. Phase angle control may comprise for capacitive loads switching off the current in a half wave after a certain fraction of the half wave, i.e. rendering a trailing edge caused by current switch-off, and/or may comprise for inductive loads switching on the current in a half wave after a certain fraction of the half wave has passed, i.e. rendering a leading edge caused by current switch-on. For ohmic loads, it may be any of the two. The mode may be manually selectable, e.g. at the time of installing the dimmer, or may be self-setting in that the dimmer has an automatic detection mechanism for determining the type of load - capacitive or ohmic or inductive - and then setting the switching mode appropriately. But in all cases, the power control circuit sits in one of the power supply lines and switches it open for a fraction of the overall time, thus providing in average over time a fraction of the maximum possible power to said load. It is pointed out here that the load may be one single electrical consumer, such as a light bulb or a dimmable AC supply for LED lighting. But the load may also comprise plural of them, preferably connected in parallel to each other.

Dimmers may be of two-wire layout or of three-wire layout. In the two-wire layout, the dimmer is only connected into the cut-open ends of one of the power supply lines of the consumer. In the three-wire layout, the dimmer is additionally connected to a tap line towards the other of the two power supply lines. The latter layout facilitates internal power supply and synchronization and allows a larger range of power control, particularly towards high power transmission.

Failures may occur in the power supply installations of a load/consumer. A consumer, for example a lamp, may simply be missing or forgotten to be properly connected, for example when a lamp is not properly screwed into its socket, or connection thereto may be faulty in that it has completely fallen off somewhere in the circuit, or it is a loose contact with some kind of arcing power transmission across it. The latter is not only a question of malfunction of the devices, but constitutes also a source of fire hazard. It may thus be desirable to detect such faults automatically without requiring humans reporting such faults. It may be the case, for example, in large hotels or large office buildings.

Fig. 7 shows a circuit as known from WO 98/35237. It is an arcing fault detection system. It senses inductively an arcing current on a power supply line to a load and operates a line interrupter when a certain condition is met. In this system, power control is not the primary purpose. An interrupt is an emergency relief measure when a fault has been detected. Besides, it is only capable of detecting some few error conditions. When no current flows, it can detect nothing.

It is the object of the invention to provide a power control circuit, a monitoring apparatus and a monitoring system capable of detecting and reporting various types of faulty load connections.

This object is accomplished by the features of the independent claims.

Disclosed is a power control circuit for controlling power supply to an electrical load receiving power via two power lines from a power source. The load may be illumination or other types of ohmic or capacitive or inductive loads. The circuit comprises two terminals for being connected into one of said power lines and a switching circuit with one or more semiconductor switches connected between the two terminals for switching over between a high-ohmic state and a low-ohmic state between said two terminals. A control component is for controlling switching of the switching circuit according to a target value. A monitoring component is for monitoring a voltage across the switching circuit or a voltage derived therefrom and generating a notice information when a predetermined condition of the monitored voltage is met. A communication component capable of holding an identification information for said power control circuit and of communicating at least said identification information away from said power control circuit upon occurrence of said notice information is provided.

The above feature combination renders a switching structure for power supply. The voltage across it is monitored for the presence or the absence of certain conditions. In usual operation, the switching circuit is used for controlling power supply to the electrical consumer/load. This may take place like regular and well-known dimmer control. The power control circuit may be a dimmer. Power control may take place irrespective of the conditions detected in the voltage across the switching circuit. The monitoring component preferably monitors a voltage derived from the voltage across the switching circuit. The generated notice information may contain status information such as "ok" or "faulty", and may contain an ID (identification information).

The communication component of the power control circuit is configured for holding said identification information and adding it to a send-out message for reporting the status of the power control circuit. The ID may be inscribed into the power control circuit at a suitable point of time, for example at manufacturing or when installing the power control circuit. Inscribing may be made by hardware, for example by a series of dip switches, or may be made by a certain software supported routine. Thus, the power control circuit is capable of reporting its identity and its state towards remote so that it can be grasped there and further processed.

The monitoring component of the power control circuit comprises one or more of a high pass filter for detecting high frequency components in said monitored voltage, a threshold detector for detecting voltage peaks in said monitored voltage, a pattern analyzer for detecting the presence or absence of predetermined patterns in said monitored voltage.

In this manner, the circuit is able of detecting electric quantities that are recognizable at the power control circuit because they are recognizable from the voltage along the switching circuit. An arcing condition may be recognizable from high frequency voltage components in the voltage across the switching circuit that does usually not have high frequency components. High frequency in this context may mean a frequency higher than that of the switched power, i.e. at least higher than 50 Hz or 60 Hz, for example higher than 100 Hz or 200 Hz.

The power control circuit may comprise a third terminal for connecting the other of said power lines thereto, and may comprise a power supply circuit connected to the third terminal for generating internal supply power for components of said power control circuit.

Providing the third terminal facilitates internal power supply because without the third terminal internal power harvesting within the circuit could only be made along the voltage drop of the switching circuit, which tends to get low at high dimming angles corresponding to a relatively high commanded power. Particularly when a series of internal processing is to be made, it is preferable to have a reasonably strong internal power supply.

The power control circuit may comprise in its communication component an interface for communicating said identification information. It may also comprise a fourth terminal for inputting an indication for said power control target value and/or other control information.

The interface may be more or less complex and may be built in accordance with a standard. It can be suited to follow an established protocol and is suited for reporting status information and possibly ID information.

The power control circuit may also have a fourth terminal for inputting information. Particularly, information on the desired power control is to be input. It may insofar be a mechanical input such as a potentiometer that transforms the turning angle into an electrical value. But it may be instead or in addition a signal input receiving a related control signal from an external component. It may be a standardized interface, such as USART, KNX, EIB or the like. If necessary, also other information may be input and/or output through the fourth terminal. Insofar, the term "fourth terminal" is summarizing possibly a plurality of lines and input/output possibilities.

In terms of dimmers, a "dimming angle" is used as denomination of a target value or an actual value of the power quantity commanded or supplied to the load. An AC half wave corresponds to an angle of π on the abscissa. A dimming angle of π in every half wave of an AC voltage (full wave corresponding to 2π) is addressed as 100% as it lets pass 100% of every half wave. A dimming angle of 0 is addressed as 0% as it blocks every half wave completely. The relative value in percent preferably refers to time = angle percent values, but may also refer to power percent values. Accordingly, dimming angle DA and dimming target value qualitatively correspond to each other.

Preferably, the power control circuit and its components are configured for switching AC voltage by phase angle control. The AC voltage may be that of an AC supply grid, e.g. of 230 V 50 Hz or of 110V 60 Hz. It may be leading edge control or trailing edge control.

The control component may comprise a first sync signal generator configured to generate a first sync signal in accordance with the voltage across the switching circuit used for the regular power control. It is noted right here that this voltage depends strongly on the dimming angle. The first sync signal generator may comprising two anti-parallel, series-connected diodes, preferably in cathode-to-cathode series connection, said series connection being connected between the terminals of the switching circuit or between the first and the second terminal. Further, a signal shaping circuit can be connected to the connection point of the diodes for shaping the first sync signal from the voltage at said connection point, particularly for bringing it to a suitable amplitude range. The signal shaping circuit may be or comprise a voltage divider, such as a resistor chain. The monitoring component is configured for monitoring the first sync signal, particularly threshold monitoring.

In this manner, the signal monitored by the monitoring component is suitably shaped from the signal across the switching circuit so that a meaningful signal is generated for monitoring purposes. Signal-shaping is made for bringing the derived signal to the amplitudes used within the circuit for signal processing.

The power control circuit may have, when in three wire connection, a second sync signal generator configured to generate a second sync signal also in accordance with the potential at the third terminal. The second signal may be utilized for synchronizing the regular switching operation of the regular dimming control on the waveforms in the controlled AC voltage. The second sync signal may also be integrated into the monitoring of the connection status.

The switching circuit may comprises two transistors in a series-connection, preferably MOSFETs, preferably of n-channel, preferably of same type, preferably counter-connected, i.e. drain to drain or source to source, for example both being STF11NM80 or both being STFU23N80K5, wherein the series connection may comprise a measurement resistor, possibly connected between the two transistors.

Two transistors in series connection are provided because the internal body diodes of the MOSFETs together with two further counter-connected diodes render a full wave rectifier. Such a rectifier can be used for the internal voltage supply. Another function of the series connection of the two MOSFETs appears in the control of inductive loads, called "RL-mode". Due to the body diodes, the switch-off is current-controlled.

A first terminal of an internal power supply may be connected to the connection point of the two transistors or to one of the connection points of the resistor,
wherein a diode is connected with its one diode terminal to the third terminal and forms with its other diode terminal the second terminal of the internal power supply.

Thus, the internal power supply may comprise a half wave rectification rendered by said diode. The first terminal may be seen as "virtual ground". The second terminal receives its potential from the half wave rectification through said diode. The voltage may again be shaped to suitable levels and may comprise one level or two levels or three or more levels. Preferably, it may comprise a higher DC level between 10 V and 20 V for driving the dimming switches/transistors, and may comprise a lower level, preferably between 2 V and 5 V, for operating internal logic circuits.

The power control circuit may comprise a digital controller implementing at least parts of said monitoring component and preferably also of said control component and/or of said communication component, and an A/D converter for converting the first sync signal into a digital format, and preferably also for converting the second sync signal into a digital format. The digital controller may comprise a microcontroller or microcomputer with appropriate interfaces such as USART, KNX, EIB, WIFI, loT or the like.

The digital signal processor may comprise a RAM, a ROM, registers, a processing unit, a PROM and a line-bus connecting these components. Analog/digital converters at the input side and digital/analog converters at the output side may be provided. The ROM may hold program data for programs required for implementing the various mentioned functions. The RAM may be provided for holding interim data. The PROM (possible an EPROM) may be provided for inscribing identification information therein. The digital controller may implement both regular dimming control and the monitoring of the available signals as far as feasible on the digital side. It may also contribute to communication and interfacing, as far as feasible on the digital side. The digital controller may be configured for multitasking so that it can execute the various tasks (dimming control, signal monitoring, communication) in alternating and time interlaced manner.

For detecting faulty load connections, the monitoring component may be configured for monitoring the voltage across the switching circuit or said voltage derived therefrom also under consideration of one or more of the following circumstances:
- switching circuit "on" or "off", represented by its switching control signal,
- the power control target value being either high or low which is a user input of a target value, noting that the user here may also be some kind of automated device, the target value possibly input as an already high level processed signal, for example through a USART, KNX, EIB interface, possibly in digital coding,
- RL mode with "R" for resistor and "L" for inductivity for resistive or inductive loads or RC mode with "R" for resistor and "C" for capacity for resistive or capacitive loads, and respectively corresponding to leading edge control or trailing edge control which is a set information or an information automatically detected in a certain known manner.

The monitoring component may monitor the first sync signal in relation to one or more voltage thresholds for finding faulty load connections.

In this manner, different monitoring modes may be implemented. A preferred first mode may be off-mode, i.e. monitoring the monitored signal while the transistors of the switching circuit are off, i.e. having high resistance between drain and source. Another mode may be on-mode, i.e. evaluating the available signal when the switching transistors are on, i.e. having low resistance between drain and source.

The off-mode may be used for lower power values, wherein "low" may mean here "not high" dimming angles commanded for the load, while the on-mode may be used for higher power values , wherein "high" may mean here "not low" dimming angles commanded for the connected load. The dimmed power commanded towards the connected load may theoretically range between 0% and 100% of what is possible. The two ranges "low"="not high" and "high"="not low" may overlap.

The monitoring component may be configured to monitor the sync signal for a first voltage threshold when the power control target value is below a first threshold while the transistors are off for detecting faulty load connections.

Generally speaking, a threshold monitoring may be made once or plural times in a half wave in timely relation to transistor switch-over, depending on whether monitoring is to be made in on-mode or off-mode.

For monitorings in the off-mode, one or more monitorings may be made in a monitoring time window that may
- for trailing edge control - also called "RC mode" and "Phasenabschnitt" in German language and used for ohmic and capacitive loads - start early after switch off to high-ohmic state, for example after a lapse of 1 % or 2% to 4% or 6% of the half wave duration. It may end appropriately thereafter, for example after start after a duration of more than 5% or 10 % and possibly less than 20% of the half wave duration, and
- for leading edge control - also called "RL mode" and "Phasenanschnitt" in German language" and used for ohmic and inductive loads - end shortly before transistor switch-on to low ohmic state, for example 1% or 2% to 4% or 6% of the half wave duration. It may start appropriately before that, for example more than 5% or 10 % and possibly less than 20% of the half wave duration before end.

Details thereof will be explained later. It is pointed out insofar that switch-over timings of the dimming transistors are internally known quantities so that, accordingly, monitoring timings can be adapted thereto by the internal controller. A threshold comparison may then be made at least once in said monitoring time window shortly after switch-off in trailing edge control or shortly before switch-on in leading edge control. For example, in trailing edge control the time window may start with a time delay after switch-off of at least or higher than 2% or higher than 4% and may end at most or lower than 15% or lower than 8 % of the half wave duration. In a 50 Hz system (half wave duration 10 ms), it could be made, for example, 500 µs after switch-off, corresponding to 5% of the half wave duration. The monitoring time window could start 200 µs or 400 µs after switching and could end 1500µs or 800 µs after switching.

For monitorings in the on-mode, the monitoring time can correspondingly be set in relation to the switching edge, i.e. before switch-off in trailing edge control or after switch-on in leading edge control.

Likewise, the monitoring component may be configured to monitor the sync signal for a second voltage threshold when the power control target value is above a second threshold that is the same as, or lower than, the first threshold while the transistors are on. Timing of monitoring or threshold comparison may be as defined above. When the transistors are switched-on, off-mode detection is disabled and on-mode detection can be enabled and made instead. On-mode can detect electrical arc on the output of the dimmer.

In both modes, the sync signal may be evaluated for detecting faulty load connections. In both modes, it may be monitored in relation to a voltage threshold and/or for high frequency components.

The communication component may comprise and be configured to use a wire-based interface, preferably a USART, KNX or EIB interface or an I2C interface or a modulator for the power lines, or may comprise and be configured to use a wireless interface, preferably WiFi, Bluetooth, RFID, loT, and is preferably configured to communicate implicitly or explicitly said identification information and preferably a status information periodically or upon occurrence of an internal or external event.

Parts of the communication component may reside on the digital side when a digital controller is provided. This may include assembling the message to be sent out and performing overall communication control. The communication itself will most likely require some kind of more or less analog signal handling and will then take place outside the digital controller.

It may be preferred that for communication purposes the power control circuit uses existing topologies, for example WiFi for the IP protocol, internet of things (loT) structures, or the like. The interface sends information such that it can be received by an appropriately configured receiver. Communication may include wireless communication or may rely on wired communication paths.

The communication component may be configured for receiving an indication for said power control target value. The power control circuit may also comprise an input means for manually inputting an indication for said power control target value. Such input indications can internally be converted into a target value, also called "dimming angle" in the field, for controlling power supply by controlling switching of the switches in feed-forward or feedback manner.

It may also comprise an output means for locally outputting a status information generated by said monitoring component. The local output means may be a little LCD or a simple LED for providing, in addition to the remote reporting, also a local output of the status information generated by that monitoring component. Then, the monitored status is also locally recognizable. Generally, local and/or communicated output may, for example, be provided only when a critical condition is found and not when a regular condition is found.

As for AC power control, the power control circuit may comprise a digital controller taking over significant parts of the regular switching control, monitoring control and communication control.

The described power control circuit may be a dimmer. It may have a housing suited for flush-mounting. It may have a mechanical input for inputting an indication for said power control target value or dimming angle.

The housing may be formed to be inserted into a standardized flush mounting box or possibly into a twin flush mounting box inserted into the wall of a building. The mechanical input may be a potentiometer that renders through its variable resistance a variable electrical value/voltage as an indication for the desired power control target value. This voltage can then be digitized for example towards said dimming angle indication and can be further used.

A monitoring apparatus is configured for receiving a message and particularly an identification information and/or a status information from one or more communication components of one or more power control circuits as described above and/or in the following that are in communication connection with said monitoring apparatus. It may have an output device for outputting an information.

The monitoring apparatus is the counterpart of the power control circuits described so far. In its communication capabilities, it is built for matching those of the power control circuits. It may be able to manage plural communication standards. It may comprise a table tabulating IDs of power control circuits against their respective mounting location that has been set when installing the devices. Then, referring to the table, the location of a messaging device can be inferred from its ID.

The monitoring apparatus may also have managing functions of periodically polling the logically connected power control circuits and receiving in response to a polling request a response. The output may be a display on a screen or may be a digested report sent, for example as an email or as a database entry, to somewhere else and including, for example, IDs, positions, and dates/times of detected faulty power supply structures.

A monitoring system comprises a monitoring apparatus as claimed or described in this specification and one or more power control circuits as claimed and connected to said monitoring apparatus.

In the following, features of the invention will be described with reference to the attached drawings in which
- Fig. 1: is a block circuit diagram of the power control circuit,
- Fig. 2: is a detailed circuit of the power control circuit,
- Fig. 3: is a visualization of the possible monitoring modes,
- Fig. 4: shows the overall system,
- Figs. 5a to 5f: are waveforms that may occur in AC power control,
- Fig. 6: are timing explanations, and

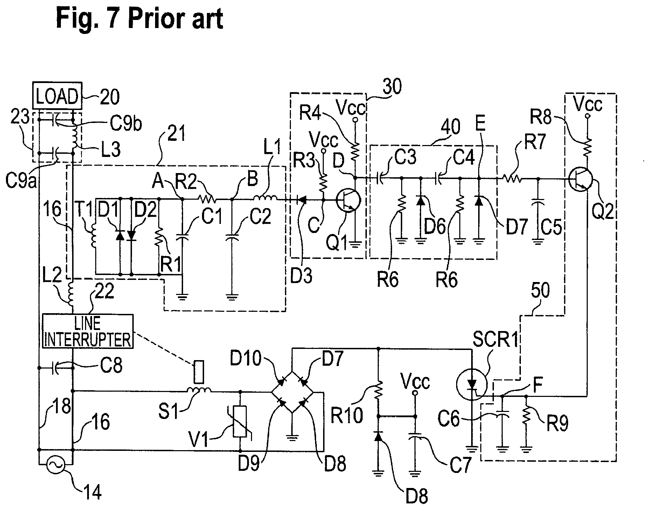

- Fig. 7: is prior art.

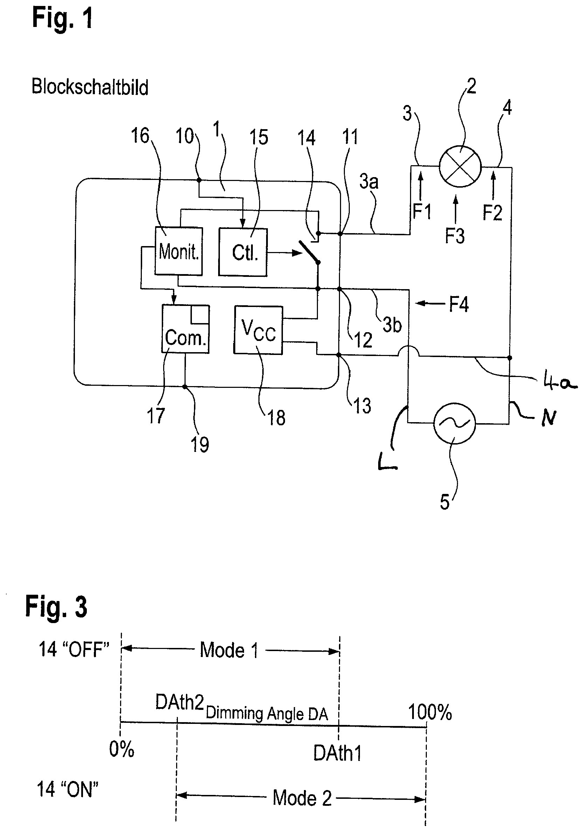

Fig. 1 is a block circuit diagram of the power control circuit 1. It controls power supply to a load or a consumer 2, visualized as a lamp. Power is supplied from a source 5, which may be a conventional AC power supply such as 230 V at 50 Hz or 110 V at 60 Hz. Power supply from source 5 to load 2 is made through two lines 3 and 4. One of them, line 3, is cut open to have two open ends 3a and 3b. They are connected to the power control circuit 1, within which conduction-state between these two open ends 3a and 3b is controlled by its switching circuit.

The power control circuit 1 comprises the switching circuit 14 visualized as a simple switch and usually implemented by at least one transistor, preferably an FET, preferably a MOSFET. The switching circuit 14 is connected between two terminals 11 and 12 of the power control circuit 1 to which the two open ends 3a and 3b of supply line 3 between source 5 and load 2 are connected. Thus, by switching the switching circuit 14, power supply from source 5 to load 2 can be controlled.

The power control circuit 1 comprises a control component 15 for controlling the switching circuit 14. This is for the regular power control operation, e.g. dimming operation, and may, for controlling AC power, comprise phase angle control. The power control circuit 1 may be provided with a terminal 10 for receiving a target value for the regular power control. It may be an analog or digital electrical input or it may be a mechanical input through a potentiometer. The control circuit 15 is suited for converting the target value indication input through terminal 10 into suitable control commands for switching circuit 14, e.g. for performing the desired phase angle control, and it may comprise one of switching on or switching off the switching circuit during a half wave of AC power.

The power control circuit 1 further comprises a monitoring component 16 for monitoring the voltage across the switching circuit 14 for detecting faulty load connections, which may be the same as the voltage between the two terminals 11 and 12 of the power control circuit 1.

Fig. 1 shows on the right side with arrows F1, F2, F3 and F4 locations where errors or unwanted situations may occur. Actually, since three individual conductor parts can be identified, namely uninterrupted line 4 and line 3 interrupted into 3a and 3b, failures F1, F2 and F4 indicate respective failures in one of these line parts. The failures may, for example, be a loose connection at one of the ends of the lines leading to an arcing condition or a so-called "loose wire" or "Wackelkontakt" in German language. But likewise, the load itself may be faulty or mis-connected, symbolized by error F3. It may, for example, simply be missing or may have an internal failure resembling a line interruption or resembling again a loose wire connection.

The faults F1, F2, F3 and F4 as symbolized in Fig. 1 translate into certain patterns in the voltage across terminals 11 and 12 or across switching circuit 14 and are thus detectable from said voltage.

The monitoring circuit monitors the voltage across terminals 11 and 12 or across the switching circuit 14 for detecting faulty load connections and is configured to generate a status indication. The status indication may, for example, be something like "normal" or "irregular" or may be, more sophisticated, be "normal" or "irregular 1" or "irregular 2" according to predefined conditions.

The monitoring component 16 itself generates said status indication. A communication component 17 is provided for assembling a message and explicitly or implicitly communicating said status indication away from the power control circuit 1. The communication component 17 is also capable of holding an identification information for said power control circuit 1, and it may either transmit said identification information together with the status information away from the power control circuit, or it may transmit the status information with or without said identification information when a polling request including the own identification information has been received. The system layout may also be to send only when a fault is detected, so that sending such a message itself is an implicit sign for failure.

The communication component 17 may communicate a message, e.g. the status information, in response to a certain event, such as a received polling request including its own ID, or periodically or in response to a status information indicating a failure being obtained.

As recognizable from Fig. 1, the power control circuit 1 has internal components such as the switching circuit 14, the control component 15, the monitoring component 16 and the communication component 17. For operating these components, an internal power supply 18 is provided. It may "harvest" power from the voltage drop between terminals 11 and 12 as long as they are not low ohmic connected by the switching circuit 14, and may have an own power storage, such as a capacitor. But likewise, the power control circuit 1 may have a third terminal 13 connected to a tab 4a towards the other power supply line 4. Then, the full supply voltage of source 5 is available in the power control circuit 1 and can be used for internal power supply. When being a conventional AC power supply grid and having the three-wire connection scheme, a half wave rectification is often sufficient for providing internal power by said internal power supply circuit 18.

The power control circuit as described may be a stand-alone circuit in an own housing. It may be a dimmer. It may be suited for flush mounting in a wall and may have a housing suited for flush-mounting. It may have a mechanical input for inputting an indication for said power control target value, such as a dimmer knob or wheel ready to use by a person. But likewise, for remote control applications, it may be some kind of housing suited for mounting in a mounting control cabinet or the like. Then, the housing may be shaped overall cuboid for possibly efficiently juxtaposing plural of them.

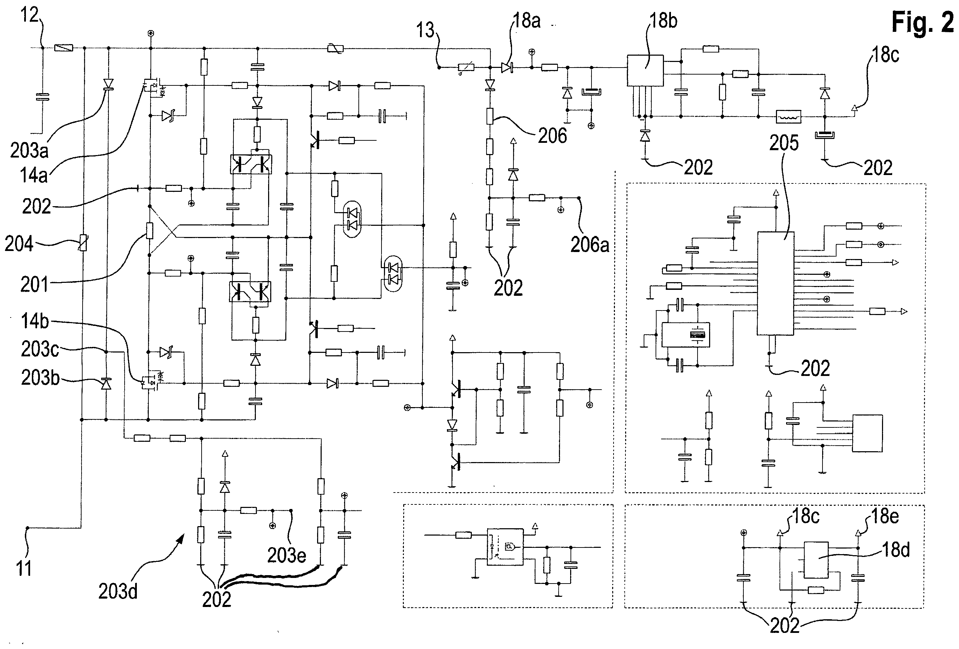

Fig. 2 shows an overall circuit of the power control circuit 1. Although the circuit in Fig. 2 is shown as a unit, it is not intended to teach thereby that an overall circuit needs to have all shown elements. Rather, components, and particularly main components of functional groups in said circuit diagram can individually be used without other components. Same numerals as in other Figures of this application shall denote same features. They are not described here again.

14a and 14b are two transistors practically in series connection for performing the regular dimming control preferably by phase angle controlled on-off-switching . For hardware short circuit detection, a very small resistor 201 acting as a shunt may be connected between them. Its value may be below 1 Ω or below 0,1 Ω. Terminal 202 forms virtual ground for the power supply within the power control circuit.

Numerals 203a and 203b are two opposing diodes connected between the terminals 11 and 12 just as the transistors 14a and 14b. Diodes 203a and 203b serve to generate the mentioned sync signal. It is tapped off at node 203c and led to a signal shaping circuit 203d for adjusting and possibly limiting the amplitude of the sync signal and possibly also providing some filtering. The signal shaping circuit 203d may comprise a voltage dividing structure voltage such as a dividing resistor chain formed by serial resistors connected towards virtual ground 202. At terminal 203e, the sync signal appears. A smoothing capacitor of suitable size may be provided.

A high ohmic varistor or resistor 204 is provided between terminals 11 and 12 for pulling the potential at terminal 11 onto that of terminal 12 for establishing defined states when the potential at 11 should otherwise be floating.

18a is a diode for providing half wave rectification for the internal power supply. Its cathode is connected from the third terminal 13 to a smoothing capacitor and is guided into an IC 18b for power formation. A stable DC power against virtual ground 202 is formed. It may have a voltage of 15 V ± 2 V. It is available at terminal 18c. Said terminal 18c is shown again in the lower right corner of the circuit. Its potential of around 15 V is led into a further IC 18d that generates a lower voltage of for example 3.3 V ± 1 V against virtual ground 202, available at terminal 18e and suitable for logic circuits.

205 is an integrated circuit (IC) that may comprise digital and possibly also analog components and constitutes a controller for various purposes. IC 205 may comprise all in one a CPU, a RAM, a ROM, registers, an (E)PROM, a bus, one or more analog/digital converters, one or more digital/analog converters, the converters possibly used in multiplexing operation for various signals, threshold detectors on the analog side and possibly other analog circuitry. It may be an ASIC.

Said IC 205 provides primarily the regular dimming control for controlling the power supply towards the load/consumer by controlling formation of the gate signals towards switching circuit 14 resp. transistor/s 14a,b. Accordingly, it generates one or more switching control signals at its output used for generating driving signals for the gates of the transistors 14a and 14b. It may receive feedback values.

At one of its inputs, IC 205 receives the target value indication for the desired power control ratio or dimming angle DA. The input may be a simple analog value in a known scaling, converted into a digital format for representing the dimming target value. But likewise, IC 205 may have a standardized interface for receiving processed or preprocessed information. It may have a UART interface through which, from another external electronic component, dimming angle information is received. this may happen periodically, for example every 100 ms, corresponding to five full waves at 50 Hz. From the received - and possibly updated - dimming angle information, the IC 205 can compute switching timings relative to the sync signals and can command their implementation.

IC 205 receives also the sync signal from terminal 203e used for monitoring as described above and also below.

The overall circuit of Fig. 2 may also comprise a second sync signal generator 206 preferably connected between the third terminal 13 and virtual ground 202. It is pointed out in this context that virtual ground 202 is in Fig. 2 only at some occurrences provided with numeral 202, but not at all occurrences. Thus, absence of numeral 202 does not mean that the respective ground symbol is not virtual ground. The second sync signal generator 206 may again include a voltage dividing resistor chain, a smoothing capacitor and finally a terminal 206a, at which the second sync signal is available. The second sync signal may be used for regular switching/dimming control, but may also be used for monitoring purposes.

IC 205 receives also the second sync signal from terminal 206a. Analog signals reaching into IC 205 can be A/D converted at its input, possibly in multiplexing manner by one single A/D converter or by plural A/D converters. Also, a target value indication for power/dimming control is input into IC 205.

The IC 205 is the above-mentioned controller that performs the respective tasks assigned thereto. IC 205 may also comprise circuitry for performing communication tasks. This may include the formation of analog signals to be output towards an external device. These signals constitute those generated by the already described communication component 17.

IC 205 or another structure in the circuit may also hold identification data (ID data) for identifying the power control circuit within which the IC 205 is situated. Said ID data can be set upon installation, or they can be preset uniquely during manufacturing of the power control circuit or the IC 205. The ID data 205 can be used to be added to a message sent out from the power control circuit as a sender identification. Additionally or instead, it can be used for recognizing a polling message received by the power control circuit as relating or not relating to the own power control circuit when such polling messages have identification data therein. Circuit 205 may also determine whether and/or when to send out a message. It may check the events set for sending out the messages.

IC 205 may also incorporate therein the structures necessary for monitoring the voltage across the switching circuit 14, particularly across the series connected transistors 14a and 14b, and particularly for monitoring the sync signal at terminal 203e, fed to its input, for detecting faulty load connections. Said monitoring structures may be a threshold decision against virtual ground 202 to which also IC 205 is connected. A threshold decision may be made on the peak value of the sync signal or on instantaneous values at a certain timing in relation to transistor switch-over. A threshold comparison may then be made once or plural times shortly after switch-off in off-mode monitoring, for example in a monitoring time window starting with a time delay after transistor switch-off longer than 2 or 4% and preferably shorter than 15 or 10 % of the half wave duration. In a 50 Hz system (half wave duration 10 ms), it could be made, for example, 500 µs after switch-off, corresponding to 5% of the half wave duration. When plural comparisons with possibly different results are made, an appropriate evaluation may be made, such as majority decision.

As far as a threshold decision is to be made, the monitoring can be made in the digital realm when the first sync signal at terminal 203e is A/D converted at the input of integrated circuit 205. Monitorings can be made on whether a threshold is exceeded or on whether a threshold is not exceeded, or whether a signal falls below, or does not fall below, a threshold, depending on signal design. But likewise, signals can be monitored for the occurrence of high frequency components or the like. Results obtained in the course of such monitoring can form events triggering the issuance of a message via communication component 17. Other events can be a certain periodicity or a request received from external.

As already said, detecting faulty load connections, also addressed as "loose wire detection" can be made in off-mode or in on-mode. Off-mode may be a monitoring of the first sync signal in OFF-state of the transistors (high ohmic state) and may reach from dimming angle 0% (power supply completely interrupted) up to a first threshold DAth1 which may be 50% dimming angle or 85% dimming angle. On-mode may be a monitoring in ON-state of the transistors (i.e. low ohmic state) and may reach from a dimming angle of 100% down to a second threshold DAth2 which may be the same as the first threshold or lower, for example 15% dimming angle. In both modes, the sync signal is evaluated.

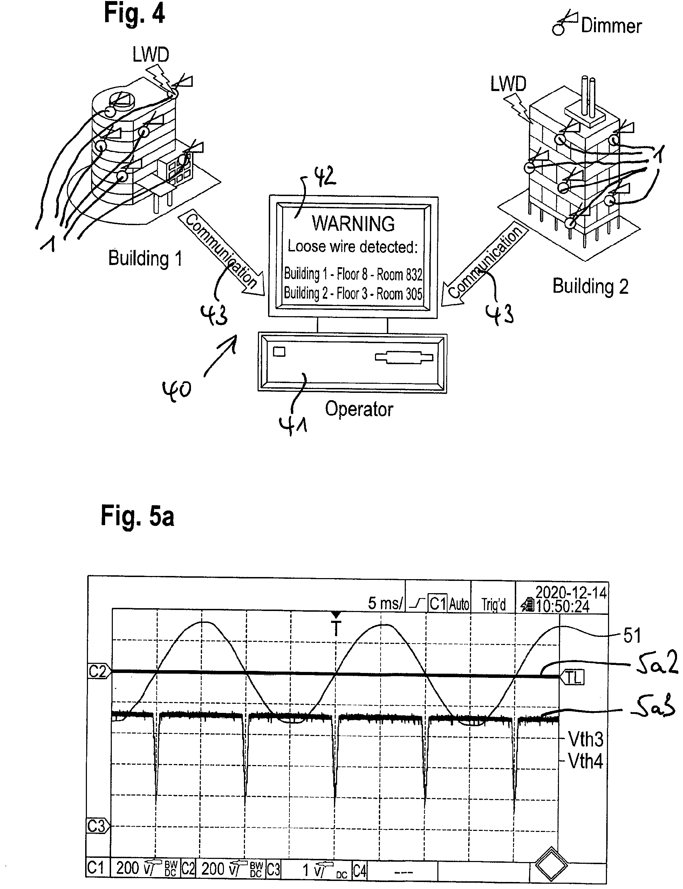

Fig. 3 visualizes ranges for possible detection modes Mode 1 and Mode 2 over the dimming angle DA as abscissa. They may correspond to off-mode monitoring for Mode 1 and on-mode monitoring for Mode 2, respectively. Mode 1 is used below a first dimming angle threshold DAth1 of for example 50% or 60% or 70% or 80% or 90%. Mode 2 is used above a second dimming angle threshold DAth2 of for example 50% or 40% or 30% or 20% or 10%. It shows that the two mode ranges may overlap when the second threshold DAth2 is lower than the first threshold DAth1, corresponding to the fact that in a phase angle controlled half wave monitorings can be made both in the on-fraction of a half wave and also in the off-fraction. Details of the expected monitorings will be described with reference to Figs. 5a to 5f further down this specification. Also to be considered here for deciding switching and correspondingly monitoring timings is whether one has an inductive load = RL mode, usually corresponding to leading edge control or "Phasenanschnitt" in German language, or a capacitive load = RC mode, usually corresponding to trailing edge control or "Phasenabschnitt" in German language. A capacitive load here is a load with a capacitive component in its impendance Z, i.e. having Z = R + 1/(jωC). An inductive load here is a load with an inductive component in its impendance Z, i.e. having Z = R + jωL.

The circuit may be configured to use only one of said modes during only one of the possible switching states of the switching circuit 14 resp. transistor/s 14a,b, or may use both of them in different switching states with suitable result arbitration amongst them, if necessary. In each of the modes, the control circuit may monitor that they are only used in their respective ranges over the dimming angle.

Assuming a dimming angle of 50% corresponding to half of the time or power of a half wave passing, the other being cut off, within said half wave both mode 1 and mode 2 can be executed, mode 1 while the switching circuit 14 resp. transistor/s 14a,b are OFF, and mode 2 while switching circuit 14 resp. transistor/s 14a,b are ON in said half wave.

Fig. 4 shows the overall system and components thereof. Visualized are larger premises, constituted, for example, by two separate multi story buildings that can altogether have dozens or hundreds of the described power control circuits in the various rooms on the various floors of the various buildings. Hotels or large office buildings can be seen as realistic fields of use. In each of the buildings in each of the stories thereof, many power control circuits 1 as described can be in use. They may be in communication connection with a monitoring apparatus 40. The monitoring apparatus will most likely be remote to most or all of the power control circuits so that the communication connection 43 has to bridge a certain distance. As said earlier, said communication may use established infrastructures either at least in parts wireless or through wired connections. They may follow established standards such as loT technology, internet protocol, WiFi, USART, KNX, EIB, I2C or the like. Monitoring apparatus 40 is suited for handling, and possibly managing, the communications with said power control circuits 1. The system layout may be a master-slave layout with the monitoring apparatus 40 possibly being the master, or may be a peer-to-peer layout with appropriate routines for handling communication access etc..

In the one or other manner, monitoring apparatus 40 may reach communications from individual ones of the power control circuits in distinguishable manner such that the monitoring apparatus receives information from which particular ones of the many power control circuits a respective message was received.

The monitoring apparatus 14 may hold a table in which the various mutually different IDs of the various power control circuits 1 integrated into the system are tabulated as input against their location as output. The location may be a building identifier, a floor identifier, a room identifier and possible further identifiers as required. Thus, the monitoring apparatus 40 is able of retrieving the affected location from the identified ID by use of said table so that related information can be output and maintenance can directly be sent to the right location without the need of looking for the failure.

The monitoring apparatus may comprises a suitably configured computer 41 and an output device 42. The output device 42 in Fig. 4 is visualized as a screen. This is a realistic possibility. It may be the screen of a PC in the office of a janitor so that here a janitor knows what needs to be done where. Instead or in addition to a screen, the output means may be or comprise a communication means that sends an appropriate notification out. It may be an email with related tabulated information thereon, or it may be a database entry or the like.

Figs. 5a to 5f show various signals as they could possibly appear. All waveforms are taken from trailing edge control also called "RC mode" or "Phasenabschnittssteuerung" in German language and used for capacitive or ohmic loads. Before turning to the Figures, the following table shows the monitoring modes in accordance with the dimming angle DA and in accordance with the switching states ON = low-ohmic or OFF = high ohmic of the transistor/s 14a,b or switching circuit 14. As said earlier, mode 1 may be during switching circuit 14 or transistor/s 14a,b being OFF and dimming angle DA below a first threshold DAth1, whereas mode 2 may be used while transistors are ON and the dimming angle DA is above a second threshold DAth2. The switching states of the switching circuit 14 resp. transistor/s 14a,b can be obtained in accordance with a respective switching circuit or transistor switching control signal as output for said transistor switching control, e.g. by IC 205. Other suitable signals may be used instead.

**Table 1: Detection modes in the sync signal in accordance with switching state and DA**

| | DA < DAth1, e.g. 85% | DA > DAth2, e.g. 15% |
|---|---|---|
| Monitoring while transistor/s 14 ON (low-ohmic) | --- | Mode 2: C2: loose wire when Vsync > Vth4 |
| Monitoring while transistor/s 14 OFF (high ohmic) | Mode 1: C1: loose wire when Vsync < Vth3 | --- |

The above table applies both for leading edge control and for trailing edge control. The difference amongst the two regimes is the placement of the monitoring window in relation to switch-over timing. This is represented by the following table:

**Table 2: Monitoring time window in accordance with switching state RC/RL mode**

| | Trailing edge control = RC mode | Leading edge control = RL mode |
|---|---|---|
| Monitoring while transistor/s 14 ON (low-ohmic) | monitoring time window before switch-off in half wave | monitoring time window after switch-on in half wave |
| Monitoring while transistor/s 14 OFF (high ohmic) | monitoring time window after switch-off in half wave | monitoring time window before switch-on in half wave |

In mode 1, a condition C1 is monitored as criterion for detecting a loose wire. In mode 2, a condition C2 is monitored as criterion for loose wire detection.

In a more complex system, both conditions may be spectrum evaluations monitoring for high frequency components in the monitored sync signal as such components are a sign of loose wire connections.

In addition or instead, threshold decisions against one or more voltage thresholds Vth can be made on the sync signal voltage Vsync. In mode 1 it can be monitored in OFF state of the transistor/s 14 whether within a half cycle the monitored sync signal voltage drops below a given first DC voltage threshold Vth3 of for example 50% or 70% or 90% of the internal DC power supply voltage for the integrated circuit. As said earlier, this monitoring can be made in a defined time window in relation to the switch-off command. If such a drop is found, it would be considered an indication of a loose wire. In mode 2, the sync signal voltage can be monitored in ON state of the transistor/s 14 for whether it exceeds a given second DC voltage threshold Vth4 of for example 50% or 30% or 10% of the internal DC power supply voltage for the integrated circuit, which again would be an indication of a loose wire connection. Monitoring timing can be as mentioned above. The two thresholds may have the same value of for example 50% of said supply voltage.

Details of the above monitoring approaches appear from the description in the following of Figs. 5a to 5f.

Fig. 5a shows a failure-free situation where the load is connected properly, but overall power control is off, i.e. dimming angle DA is 0%, transistor/s 14 always OFF. Curve 51 is assumed to be the phase voltage at terminal 12 and line 3b between said terminal 12 and power source 5, measured against neutral line N 4. Curve 5a2 is the voltage at terminal 11 and line 3a, again measured against neutral line 4. Curve 5a3 is the first sync signal voltage measured against virtual ground. In Fig. 5a, switch 14 is assumed to be open, i.e. transistor/s 14 OFF, so that line 3a is pulled by the correctly connected load 2 to the potential at line 4. Curve 5a3 is the sync signal as appearing at node 203e as described earlier, kept off from the connection point of the opposing diodes shown in Fig. 2. In OFF state of the transistors - always in fig. 5a - Vsync is high and in the above mentioned monitoring window above a suitably set threshold Vth3.

As dimming angle is 0 in Fig. 5a, mode 1 would apply. The sync signal is monitored for falling below a threshold of, for example, 60% of the internal DC supply voltage. If the voltage drops below the threshold in the monitoring time window, it is a sign for a loose wire connection and thus a sign for failure. Such a detection would cause the controller to set a status indication on "faulty", possibly with the additional information that it is detected in "mode 1", and possibly supplemented with the ID of the power control circuit within which the error is detected. Such a message can then be sent out at an appropriate point of time.

Regarding the modes, it is pointed out that mode 1 is not suited for loose wire detection when loads are connected in parallel to the power control circuit. Namely, as mode 1 is used during transistors being off, the failure signal potentially occurring in one of the parallel loads would be masked by the correct wiring and behavior of the other parallel loads in OFF state which are most likely correct.

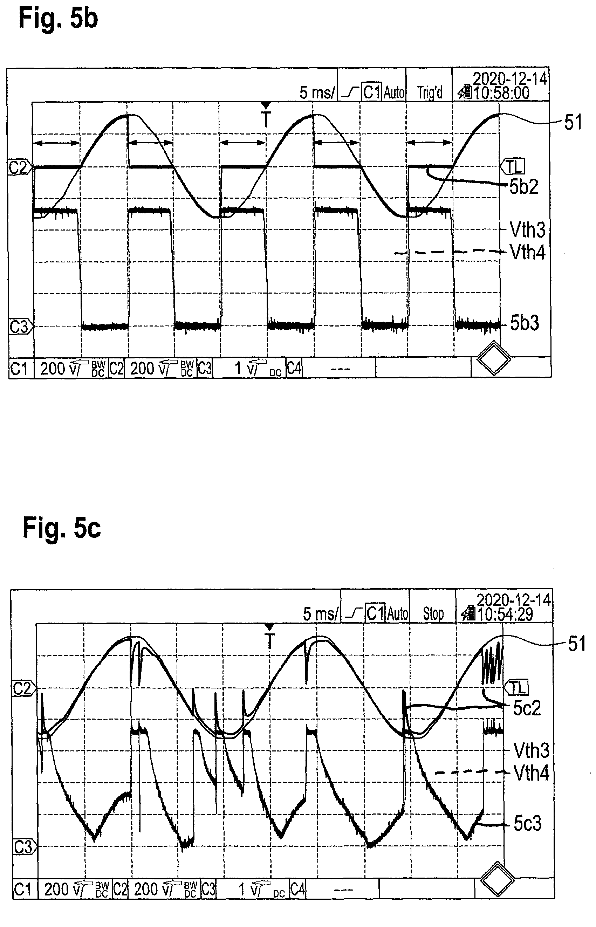

Fig. 5b shows a further failure-free state with a dimming angle of 50%, i.e. the transistor/s 14 being ON 50% of the time, otherwise OFF. In ON state, voltage 5b2 at terminal 11 follows signal 51 which is the same as in Fig. 5a because the voltage drops along the load and not along the switches 14. Vice versa, during OFF-state of the transistors 14, signal 5b2 is 0 because the voltage drops along transistor/s 14 and not along the load so that the load pulls terminal 11 to N potential. 5b3 is the sync signal.

As the dimming angle is 50%, it is a situation where both modes could be used. Both modes would not produce an error indication because in ON-state of the transistors the sync signal is practically 0 and thus below a suitable voltage threshold Vth4, monitored in mode 2, whereas in OFF-state of the transistor/s 14 the sync signal is above a threshold Vth3, monitored in mode 1.

Generally, it is conceivable that when both modes are used in parallel, they could render contradictive detection results. It can then be chosen according to desired policies whether the results from the two modes are ANDed or ORed, depending on preferences in detection safety, avoiding false alarms and the like. As in some failure situations it may systematically be that the one mode shows a failure, but not the other, it is preferred to OR the signals from the two modes.

Fig. 5c shows the situation where the load is connected to the output 11 of the dimmer by a loose wire, i.e. a loose wire being given somewhere along line 3a at arrow F1. Curve 5c2 shows the corresponding signal at terminal 12. Dimming angle is assumed to be 0%, i.e. transistor/s 14 always OFF. The sync signal 5c3 is monitored in mode 1 for falling below a threshold voltage Vth3, preferably in the above mentioned monitoring time window. It occurs in irregular patterns according to the loose wire coincidences and is thus detected as failure.

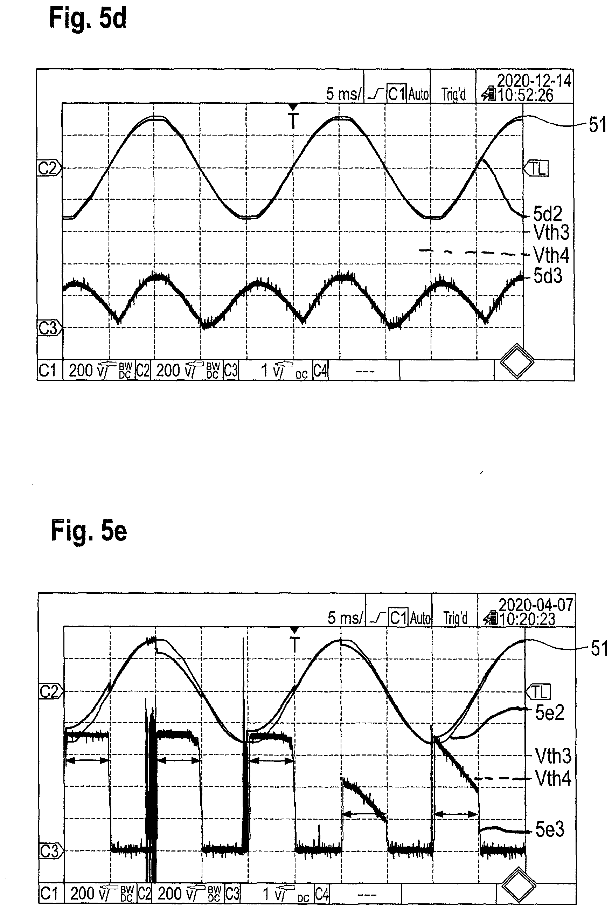

Fig. 5d shows the situation when the load is disconnected and the output is off, i.e. dimming angle at 0%. The varistor/resistor 204 pulls floating line 3a and the potential at terminal 11 to the potential of line 3b and terminal 12. The sync signal is shown by curve 5d3. It resembles a full wave rectification, but does not exceed a threshold Vth3 in transistor OFF state, thus being detectable as a failure.

Fig. 5e shows the situation that a loose wire is in mode 1 (OFF state) corresponding to arrows F1, F2, F3 in Fig. 1. A dimming angle of 50% is assumed. Again, due to dimming angle 50% both evaluation modes are possible. In OFF-state of the transistor/s 14, the sync signal 5e3 does in one of the half cycles not exceed a threshold Vth3, thus showing a failure. In ON-state of the transistor/s 14, the sync signal exceeds a threshold Vth4 in one of the cycles, thus again allowing a failure detection.

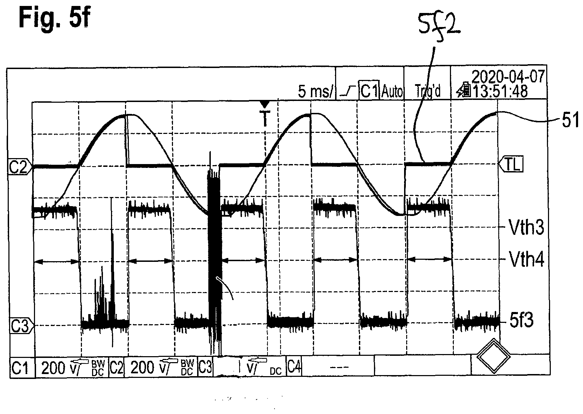

Fig. 5f shows dimming angle DA of 50% again with a loose wire on line 3a. In the conductive state of the transistors, the sync signal exhibits arcing at high voltage portions of the half wave, thus only gradually connecting power. The sync signal 5f3 exceeds a threshold Vth4 and thus exhibits a failure. It is pointed out that Fig. 5f shows the condition that might occur with parallel connected loads.

A loose wire present in one of the load loops would not be detectable during off-state of the transistors because then the faulty condition of the faulty load loop would be masked in OFF state by the correct condition of the parallel other loads. In figure 5f, the sync signal is monitored.

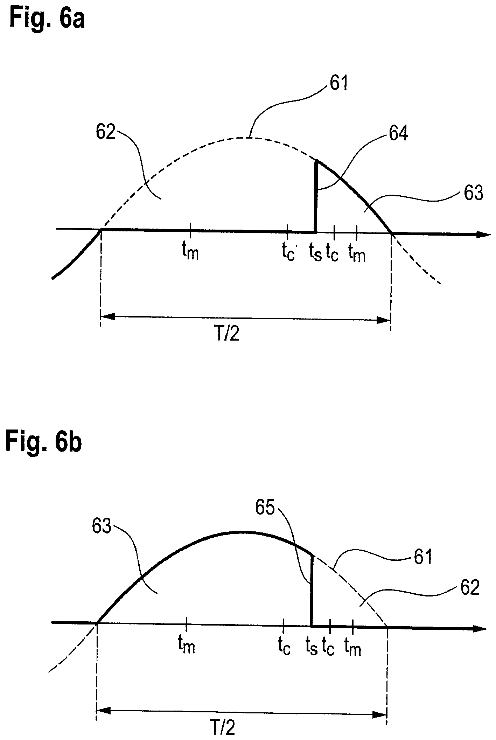

Monitoring timings may be as described further up this specification. Figs. 6a and 6b show further possibilities for the monitoring timings. Both figures show a half wave 61 of duration T/2 which is 10 ms in a 50 Hz system. Both half waves have ON-times 63 and OFF-times 62. Fig. 6a shows leading edge control having a leading edge 64 used for resistive or inductive loads. The dimming angle is below 50% as the ON-edge is after the maximum of the half wave. Fig. 6b shows trailing edge control having a trailing edge 65 used for resistive or capacitive loads. The dimming angle is somewhere above 50% as the OFF-edge is after the maximum.

Generally, monitoring time windows can be selected appropriately spaced from commanded transistor switching and from zero crossings of the half wave. Further, they may be placed in time regions where the half wave has a relatively high value.

Timings tm and tc may be monitoring timings. Timing indications tm are timings roughly in the middle of the respective ON time or OFF time. Timing indications tc are timings closer to the respective edge 64, 65. Timing indications ts are the timings of the edges 64, 65 themselves. The controller knows the period length T/2 and the edge timings ts and can, generally speaking, set monitoring timings and monitoring time windows in suiting manner during ON or OFF, depending on what kind of monitoring is desired. The monitoring timings may be at the mentioned timings tm or tc or in monitoring time windows around said timings tm or tc, for example.

In a half wave, monitorings can be made both during ON and OFF. It is not necessary that monitorings are made every half wave. They may be made only every n-th half wave, with n being larger than 5 or 10 or 100 or 1000.

As far as different monitoring modes are available, they may be chosen automatically according to defined strategies or may be commanded. They may be used in some kind of revolving manner, e.g. alternatingly, for example in the above monitoring pattern.

Although the above description describes two modes in dependence of dimming angle, it is not necessary that both of them are used or that the power control circuit is adapted to implement both of them. It can implement or be adapted to use only one of them, for example only mode 1 or only mode 2, depending on circumstances and field of use.

Features described in this specification and/or in the claims and/or shown in a figure shall be deemed combinable with and amongst each other also if their combination is not expressly described, to the extent that the combination is technically feasible. Features described in a certain context, embodiment, figure or claim shall be deemed separable from this claim, context, embodiment or figure and shall be deemed combinable with every other figure, claim, context or embodiment, to the extent that it is technically feasible. Embodiments and figures shall not be understood as being meant necessarily exclusive against each other. Descriptions of a method or procedure or a method step or a procedural step shall be understood also as description of means and/or possibly as a data carrier holding program instructions of executable code adapted for implementing the method or procedure or method step or procedural step, and vice versa.

## Claims

1. A power control circuit (1) for controlling power supply to an electrical load (2) receiving power via two power lines (3, 4) from a power source (5), the circuit (1) comprising
a first terminal (11) and a second terminal (12) for being connected into one (3) of said power lines (3, 4),
a switching circuit (14) for controlling power supply to said electrical load and comprising one or more semiconductor switches (14a, 14b) and connected with its terminals between the two terminals (11, 12) for switching over between a high-ohmic state and a low-ohmic state between said two terminals (11, 12),
a control component (15) for controlling switching of the switching circuit (14) according to a target value,
a monitoring component (16) for monitoring a voltage across the switching circuit (14) or a voltage derived therefrom and generating a status indication when a predetermined condition of the monitored voltage is met, and
a communication component (17) capable of holding an identification information for said power control circuit (1) and of communicating status in accordance with at least said identification information and said status indication away from said power control circuit (1).

2. The circuit of claim 1, wherein the monitoring component (16) comprises one or more of
one or more threshold detectors for detecting one or more voltage peaks in said monitored voltage (14),
a high pass filter for detecting high frequency components in said monitored voltage (14),
a pattern analyzer for detecting the presence or absence of predetermined patterns in said monitored voltage (14).

3. The circuit of claim 1, further comprising
a third terminal (13) for connecting the other (4) of said power lines (3, 4) thereto,
a power supply circuit (18) connected to the third terminal (13) for generating supply power for components of said power control circuit (1).

4. The circuit of one of the preceding claims, further comprising one or more of
an interface (19) in said communication component for communicating said status,
a fourth terminal (10) for inputting an indication for said power control target value and/or other control information.

5. The circuit of one of the preceding claims,
wherein the switching circuit (14) and the control component (15) are configured for switching AC voltage by phase angle control, the AC voltage preferably being from an AC supply grid, preferably of 230 V 50 Hz or of 110V 60 Hz,
wherein the control component (15) comprises a first sync signal generator configured to generate a first sync signal in accordance with the voltage across the switching circuit (14) used for controlling the switching of said switching circuit (14),
the first sync signal generator preferably comprising two diodes in cathode-to-cathode series connection, said series connection being connected between the terminals of the switching circuit or between the first and the second terminal, and comprising a signal shaping circuit connected to the connection point of the diodes for shaping the first sync signal from the voltage at said point,
wherein the monitoring component (16) is configured for monitoring the first sync signal.

6. The circuit of claim 5 and claim 3,
wherein the control component (15) comprises a second sync signal generator configured to generate a second sync signal also in accordance with the potential at the third terminal.

7. The circuit of claims 5 or 6,
wherein the switching circuit (14) comprises two transistors in a series-connection, preferably MOSFETs, preferably of n-channel, preferably of same type, preferably counter-connected,
wherein the series connection may comprise a resistive element connected between the two transistors.

8. The circuit of claim 7 and claim 3,
wherein a first terminal of an internal power supply is connected to the connection point of the transistors or to one of the connection points of the resistor,
wherein a diode is connected with its one diode terminal to the third terminal (13) and forms with its other diode terminal the second terminal of the internal power supply.

9. The circuit of one of the claims 5 to 8, further comprising
a digital controller implementing at least parts of said monitoring component (16) and preferably also of said control component (15) and/or of said communication component (17), and
an A/D converter for converting the first sync signal into a digital format, and preferably also for converting the second sync signal into a digital format.

10. The circuit of one of the claims 5 to 9, wherein the monitoring component (16) is configured for monitoring the voltage across the switching circuit (14) or said voltage derived therefrom also in accordance with a power control target value and/or in accordance with a switching control signal for, or a switching status of, said semiconductor switches (14a, 14b).

11. The circuit of one of the claims 5 to 10, wherein the monitoring component (16) is configured for determining a monitoring time (tm, tc) or a monitoring time window in accordance with a power control target value and/or in accordance with a switching timing (ts) of said semiconductor switches (14a, 14b).

12. The circuit of claim 10 or 11, wherein the monitoring component (16) is configured to monitor the sync signal for dropping below a threshold value (Vth3) within a monitoring time window set in relation to transistor switch-over to or from the state within which the monitoring is to be made when the power control target value is below a first threshold DAth1, preferably while the switching circuit (14) is OFF.

13. The circuit of claim 10, 11 or 12, wherein the monitoring component (16) is configured to monitor the sync signal for exceeding a threshold value (Vth4) within a monitoring time window set in relation to transistor switch-over to or from the state within which the monitoring is to be made when the power control target value is above a second threshold DAth2 that is the same as, or lower than, the first threshold DAth1, preferably while the switching circuit is ON.

14. The circuit of one of the preceding claims, wherein the communication component (17) comprises a wire-based interface, preferably a USART or KNX or EIB interface or an I2C interface or a modulator for the power lines, or is a wireless interface, preferably WiFi, Bluetooth, RFID, and is preferably configured to communicate said identification information and preferably a status information periodically or upon occurrence of an internal or external event.

15. The circuit of one of the preceding claims,
wherein the communication component (17) is configured for receiving an indication for said power control target value,
and preferably comprising an input means for manually inputting an indication for said power control target value,
and preferably comprising an output means for locally outputting a status information generated by said monitoring component (16).
